# EUROPÄISCHE PATENTANMELDUNG

(11) **EP 2 626 446 A1**
(43) Veröffentlichungstag der Anmeldung: **14.08.2013**
(21) Anmeldenummer: 12195221.2
(22) Anmeldetag: 03.12.2012
(51) Int. Cl.: C23C 16/04, C23C 16/26, C23C 16/40, C23C 16/455, C23C 16/509, H01J 37/32

(54) **Powerlanze und plasmaunterstützte Beschichtung mit Hochfrequenzeinkopplung**

(30) Priorität: 09.02.2012 DE 102012201955
(71) Anmelder: Krones AG, 93073 Neutraubling (DE)
(72) Erfinder: Krüger, Jochen, 93073 Neutraubling (DE); Sonnauer, Andreas, 93073 Neutraubling (DE); Gesche, Roland, 93073 Neutraubling (DE)
(74) Vertreter: Grünecker, Kinkeldey, Stockmair & Schwanhäusser

(57) **Zusammenfassung**

Die Erfindung betrifft eine Vorrichtung (100) zur Beschichtung eines Behälters (102), beispielsweise einer Kunststoffflasche, mittels Plasmabehandlung, beinhaltend,
wenigstens eine Hochfrequenzquelle (109), wenigstens eine sich außerhalb des zu behandelnden Behälters (102) befindliche Außenelektrode (103), und wenigstens eine mindestens teilweise elektrisch leitende Gaslanze (101) zum Zuführen von Prozessgas in den Behälter (102), **dadurch gekennzeichnet, dass** die wenigstens eine Außenelektrode (103) geerdet ist und/oder auf dem gleichen Potential liegt wie andere sich außerhalb des zu behandelnden Behälters befindlichen Teile der Behälterbeschichtungsvorrichtung, wie etwa Druckkammerteile oder Gehäuseteile, und die wenigstens eine Gaslanze (101) eine von der Hochfrequenzquelle (109) erzeugbare Hochfrequenz in das Innere des zu behandelnden Behälters (102) einstrahlen kann.

## Beschreibung

### Stand der Technik

Zur Verminderung der Durchlässigkeit von Behälter-/Hohlkörperwänden ist es vorteilhaft, diese mit einer Barriereschicht zu versehen, beispielsweise durch plasmaunterstützte chemische Gasphasenabscheidung / Plasma Enhanced Chemical Vapor Depositon (PECVD), wie z.B. in der EP0881197A2 beschrieben.

Zur Beschichtung von Behältnissen mittels Plasmabehandlung, beispielsweise der Plasma-Innenbeschichtung von Kunststoffflaschen, kann unter anderem ein sogenanntes Hochfrequenzplasma eingesetzt werden.

Hierbei wird z.B. ein Plasma in einer Flasche erzeugt, indem das Innere der Flasche auf einen Druck im Bereich von 1-10 Pa evakuiert und einem Hochfrequenzfeld ausgesetzt wird. Durch eine Gaslanze kann ein Gasgemisch, beispielsweise aus einem Silizium-Monomer und Sauerstoff in das Innere der Flasche eingebracht werden. Durch diesen Gasstrom kann sich der Druck in der Flasche um einige 10 Pa erhöhen und so im Bereich von 10 - 30 Pa oder darüber liegen.

Dabei kann sich außerhalb der Flasche eine flächige Elektrode befinden, die mit Hochfrequenz beschickt werden kann, beispielsweise mit 13,56 MHz. Die Gaslanze, die gleichzeitig auch Elektrode ist, besteht in der Regel aus Metall und ist über eine Verbindung mit dem Maschinengehäuse geerdet, wie beispielsweise in der W02009026869 beschrieben.

Die Hochfrequenz koppelt dabei an die Gaslanze an und es kann ein Plasma im Inneren der Flasche gezündet werden. Durch mehrere geeignet positionierte Bohrungen in der Gaslanze kann das Prozessgas in der Flasche gleichmäßig verteilt und die Flasche innen gleichmäßig beschichtet werden.

Diese Art der Hochfrequenzeinkopplung ist jedoch ungeeignet dafür, große Flächen wie zum Beispiel die Innenseite von Flaschen mit hohen Abscheideraten von mehr als >2 nm/s zu beschichten, da hierzu ein hoher Gasstrom und damit verbunden auch eine hohe elektrische Leistung in Form von Hochfrequenz benötigt wird. Die hohe Leistung führt aufgrund des elektrischen Netzwerkes, insbesondere der kapazitiven Kopplung der Hochfrequenz zwischen der Elektrode und Flasche zu sehr hohen elektrischen Potenzialen auf der Elektrode. Da die Umgebung der Elektrode, insbesondere metallische Teile im Bereich der Flaschenmündung (wie z.B. Ventil, Flaschenklammer, Gaslanze) geerdet sein müssen, entstehen durch die Hochfrequenz immer wieder unerwünschte elektrische Entladungen außerhalb der Flaschen, bzw. innerhalb der Behälterbeschichtungsvorrichtung, welche die Flasche und/oder die Behälterbeschichtungsvorrichtung beschädigen.

Diese unerwünschten elektrische Entladungen, die auch als parasitäre Entladungen bezeichnet werden können, mindern zudem die elektrische Leistung, die zur plasmaunterstützten Beschichtung des Behälters zur Verfügung steht, was eine minderwertige oder unzureichende Beschichtungsgüte zur Folge haben kann. Ausserdem können parasitäre Entladungen zu einer Fehlanpassung der Matchbox im Impedanznetzwerk führen.

### Aufgabe

Es ist somit Aufgabe der Erfindung eine Vorrichtung zur Beschichtung von Behältern mittels Plasmabehandlung, beispielsweise der plasmaunterstützten Beschichtung von Kunststoffflaschen, zu verbessern, insbesondere hinsichtlich Sicherheit und Effizienz.

### Lösung

Dies wird erfindungsgemäß durch eine Vorrichtung nach Anspruch 1 und ein Verfahren nach Anspruch 13 erreicht. Vorteilhafte Ausführungsformen und Weiterbildungen sind Gegenstand der Unteransprüche.

Eine erfindungsgemäße Vorrichtung zur plasmaunterstützten Beschichtung eines Behälters kann dabei wenigstens eine Hochfrequenzquelle, wenigstens eine sich außerhalb des zu behandelnden Behälters befindliche Außenelektrode, und wenigstens eine mindestens teilweise elektrisch leitende Gaslanze zum Zuführen von Prozessgas in den Behälter aufweisen. Die wenigstens eine Außenelektrode kann geerdet sein und/oder auf dem gleichen Potential liegen wie andere sich außerhalb des zu behandelnden Behälters befindlichen Teile der Behälterbeschichtungsvorrichtung, wie etwa Druckkammerteile oder Gehäuseteile. Die wenigstens eine Gaslanze kann dabei eine von der Hochfrequenzquelle erzeugbare Hochfrequenz in das Innere des zu behandelnden Behälters einstrahlen. Als Prozessgas kann für die Abscheidung quarzähnlicher Schichten dabei z.B. ein Gemisch aus Sauerstoff und einem gasförmigen siliciumorganischen Monomer wie Hexamethyldisiloxan (HMDSO), HMDSN, TEOS, TMOS, HMCTSO, APTMS, SiH4, TMS, OMCTS oder vergleichbarer Verbindungen, verwendet werden.

Analog können für die Abscheidung kohlenstoffhaltiger Schichten (diamond like carbon, "DLC") C₂H₂, C₂H₄, CH₄, C₆H₆ oder andere kohlenstoffhaltige Quellsubstanzen verwendet werden.

In einem erfindungsgemäßen Verfahren zur plasmaunterstützten Beschichtung eines Behälters kann dann beispielsweise dem zu behandelnden Behälter B über eine ungeerdete Gaslanze PL Prozessgas und eine Hochfrequenz HF, die an eine sich außerhalb des Behälters B befindliche geerdete Außenelektrode AE ankoppelt, zugeführt werden. Im Inneren des Behälters kann dann das Prozessgas zünden und teilweise oder vollständig in ein Plasma umgesetzt werden, und durch Gasphasenabscheidung das Innere des Behälters (B) beschichtet werden.

Die beschriebene Behälterbeschichtungsvorrichtung, bzw. beschriebenes Verfahren, hat den Vorteil, dass beispielsweise kein Plasma zwischen der Außenelektrode und Teilen der Behälterbeschichtungsvorrichtung, wie Druckkammerteile oder Gehäuseteile, durch unerwünschte Entladungen gezündet wird, da Außenelektrode und besagte Teile auf gleichem Potential liegen, beispielsweise auf Erdpotential.

Die in den zu behandelnden Behälter hineinragende Gaslanze kann dabei mindestens teilweise koaxial elektrisch abgeschirmt sein, wobei die elektrische koaxiale Abschirmung innerhalb des Behälters enden kann.

Diese optionale koaxiale Abschirmung der Gaslanze hat z.B. den Vorteil, dass der Abstrahlungsbereich der Hochfrequenz besser gesteuert, bzw. eingegrenzt wird, beispielsweise zur gezielten Abstrahlung der Hochfrequenz in das Innere, beispielsweise in die Mitte oder bevorzugterweise in das untere Zweidrittel des zu behandelnden Behälters.

Die Gaslanze kann aus einem Material bestehen, welches sowohl durchlässig für Prozessgas als auch elektrisch leitend sein kann, wie z.B. ein metallisches Rohr, oder ein poröser metallischer Schaum.

Die Gaslanze kann aber auch so ausgebildet sein, dass die Zufuhr von Prozessgas und die Zufuhr, bzw. Leitung der Hochfrequenz räumlich getrennt erfolgen kann. Dabei ist der die Hochfrequenzleitende Teil der Gaslanze elektrisch leitend, der Gaslanzenteil zur Zufuhr von Prozessgas, kann dabei jedoch entweder teilweise oder vollständig aus einem nichtelektrisch leitendem Material, z.B. Kunststoff oder Keramik, teilweise oder vollständig aus einem elektrisch leitendem Material, oder aus einer Kombination von elektrisch leitendem und nichtleitendem Material bestehen.

Die Gaslanze kann darüber hinaus über eine Vielzahl, bevorzugt seitlicher, Gaseinlassbohrungen verfügen, um das Prozessgas gleichmäßig in Behälter verteilen und somit eine gleichmäßige Beschichtung des Behälterinneren erleichtern zu können.

Aus der Gaslanze ausströmendes Prozessgas kann allerdings, beispielsweise aufgrund möglicher unerwünschter Entladungen auf oder im Inneren der Gaslanze, durch die Gaseinlassbohrungen hindurch zünden und in Form eines Plasmas eine elektrisch leitende Verbindung ins Innere der Gaslanze bilden, wo sich ein sogenanntes Hohlraum-/Hohlkathodenplasma etablieren kann.

Zur Vermeidung solcher unerwünschter Entladungen innerhalb der Gaslanze, kann die Gaslanze vorteilhafterweise z.B. eine Vielzahl von Gaseinlassbohrungen aufweisen mit Bohrungsdurchmessern kleiner als 0.1, 0.2 oder 0.5 mm und Bohrungslängen von 0.1 - 10 mm, oder die Gaslanze besteht aus offenporigen Metallschaum oder Sintermetall mit Porendurchmessern im Bereich <10-100 µm. Denkbar sind auch offenporige Keramikschäume z.B. aus Aluminiumoxid oder sonstige Oxidkeramiken.

Dies hat den Vorteil, dass Ladungsträger nicht mehr geradlinig auf Energien beschleunigt werden können, die bei einem folgenden Stoß zu einer Ionisation des Stoßpartners im Gas führen können. Gasentladungen im Inneren der Gaslanze können so vermieden bzw. reduziert werden.

Die Figuren stellen beispielhaft dar:
Fig. 1: Schematisches Beispiel einer Vorrichtung zur plasmaunterstützten Beschichtung eines Behälters.
Fig. 2a: Beispiel Gaslanze
Fig. 2b: Beispiel Gaslanze
Fig. 3a: Beispiel Gaslanze
Fig. 3b: Beispiel Gaslanze
Fig. 4a: Beispiel Gaslanze
Fig. 4b: Beispiel Gaslanze
Fig. 5: Beispiel Gaslanze
Fig. 6: Beispiel Gaslanze
Fig. 7a: Beispiel Gaslanze im Magnetfeld
Fig. 7b: Beispiel Gaslanze im Magnetfeld

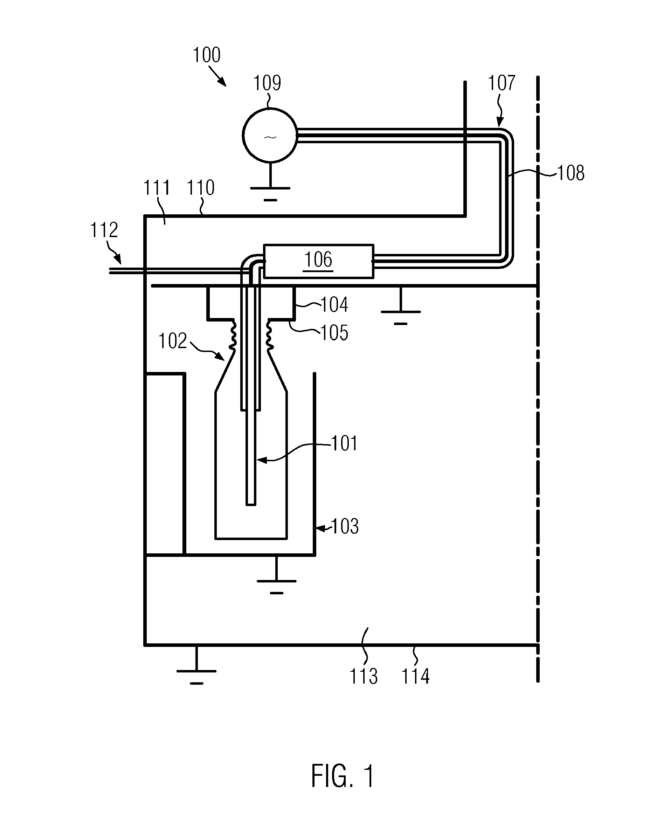

In Fig.1 ist beispielhaft eine Vorrichtung 100 zur plasmaunterstüzten Beschichtung eines Behälters dargestellt. Dabei kann die Vorrichtung 100 zwei verschiedene Druckbereiche aufweisen, beispielsweise eine Grund-Druckkammer 113, welche z.B. auf Drücke von 100 bis 4000 Pa evakuiert werden kann, und beispielsweise eine Prozess-Druckkammer 111, in welcher z.B. Drücke zwischen 1 bis 30 Pa herrschen können. Eine Hochfrequenzquelle 109 kann über ein Koaxialkabel 108 Hochfrequenz in eine Gaslanze 101 einspeisen. Wahlweise kann mittels eines Leistungsanpassers 106 durch sogenanntes Radiofrequency Matching, der Wirkungsgrad der Leistungsübertragung zwischen Hochfrequenzquelle 109 und Gaslanze 101 optimiert werden. Das Koaxialkabel 108 kann elektrisch abgeschirmt sein. Ebenso kann die Gaslanze 101 mindestens teilweise elektr sch abschirmt sein und beispielsweise eine koaxiale Abschirmung 107 aufweisen, die sich bis ins Behälterinnere, bei einer in den Behälter 102 eingeführten Gaslanze 101, erstrecken kann, bzw. bis zum Ende der Gaslanze 101, bevorzugterweise jedoch nur bis zum letzten 2/3 der Gaslanze 101, ausgeführt sein kann.

Durch eine teilweise elektrische Abschirmung der Gaslanze 101, kann die Ausstrahlung der Hochfrequenz in das Behälterinnere gezielter erfolgen, und es können beispielsweise unerwünschte Gasentladungen im Bereich der Behälteröffnung / Flaschenmündung an metallischen Teile wie z.B. Ventil 104, Flaschenklammer 105, etc. reduziert oder vermieden werden. Die Grund-Druckkammer 113 kann über eine Außenelektrode 103 verfügen, z.B. in U-Form, die den zu behandelnden Behälter 102 mindestens teilweise umfassen kann, ohne den Behälter 102 zu berühren, da der Behälter 102 beispielsweise über eine Flaschenklammer 105 aufgehängt sein kann. Die Außenelektrode 103 kann beispielsweise elektrisch mit einem Teil des Grund-Druckkammergehäuses 114 verbunden sein, und kann darüber so z.B. geerdet sein.

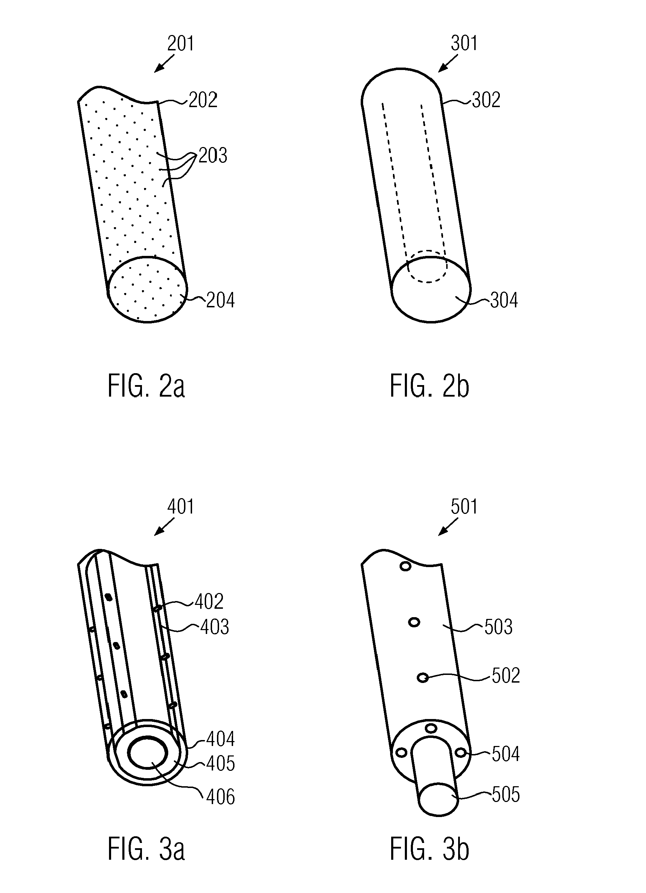

Fig. 2a zeigt ein Beispiel einer Gaslanze 201, die aus einem Material bestehen kann, welches sowohl elektrisch leitend ist und die Hochfrequenz leiten kann, als auch gleichzeitig das Prozessgas zuführen kann. Dabei kann die Gaslanze 201 ein metallischen Rohr 202 sein, welches beispielsweise eine Vielzahl, z.B. 1 bis 10 oder mehr Bohrungen pro cm², von Bohrungen 203 aufweisen kann, welche z.B. bevorzugt seitlich angebracht sind und vorteilhafterweise Bohrungsdurchmessern kleiner als 0.1, 0.2 oder 0.5 mm aufweisen können. Dabei kann das Rohr 202 am Ende 204 verschlossen sein. Ein verschlossenes Ende 204 kann zusätzlich Bohrungen BL, z.B. axial ausgeführt, zum Durchlass von Prozessgas aufweisen.

Die Vorrichtung der Fig.1 kann als Karrussel verwirklicht werden, bei dem die Behälter 102 auf einer Kreissegmentbahn geführt werden können, während sie durch den Bereich der Plasmabehandlung laufen.

Fig. 2b zeigt ein weiteres Beispiel für eine Gaslanze 301, die gleichzeitig elektrisch leiten und eine Hochfrequenz zuführen kann, als auch zur gleichen Zeit Prozessgas zuführen kann. In diesem Beispiel kann die Gaslanze 301 aus einem Rohr 302 aus metallischem Schaum, beispielsweise aus offenporigem Aluminiumschaum mit Porengröße < 10-100 µm ausgebildet sein. Dabei kann das Rohr 302 am Ende 304 verschlossen sein oder ebenfalls aus einem offenporigen Metallschaum bestehen. Ein verschlossenes Ende 304 kann zusätzlich Bohrungen, z.B. axial ausgeführt, zum Durchlass von Prozessgas aufweisen.

Bei einer weiteren vorteilhaften Ausführung einer Gaslanze, kann die Gaslanze beispielsweise einen metallischen Kern zur Leitung der Hochfrequenz aufweisen, während das Prozessgas außerhalb des metallischen Kerns in einem elektrisch isolierenden Material dem Behälter zugeführt werden kann.

Fig.3a stellt beispielsweise eine Gaslanze 401 dar, welche z.B. als Vollmaterial einen massiven metallischen Kern 406 aufweisen kann, der als Antenne zur Übertragung der Hochfrequenz dienen kann. Um den metallischen Kern 406 kann sich dabei ein Doppelrohr 403, z.B. bestehend aus Kunststoff oder Keramik, befinden. Die beiden Rohre 405, 404 des Doppelrohres 403 können dabei ineinander liegen und einen Abstand voneinander von 0.1 - 2 mm, bevorzugt 0.5 mm, aufweisen. Das äußere Rohr 404 kann dabei Bohrungen 402, bevorzugt seitlich und bevorzugt mit Bohrungsdurchmessern < 0.5 mm, aufweisen, damit das Prozessgas, bevorzugt seitlich, ausströmen kann und sich gleichmäßig im Behälter verteilen kann.

Fig.3b stellt beispielhaft eine weitere mögliche vorteilhafte Ausbildung einer Gaslanze 501 dar. Dabei kann ein massiver metallischen Kern 505 von einem Kapillarrohr 503, z.B. bestehend aus einem keramischen Material, umschlossen sein, welches Kapillare 504, bevorzugt parallel zur Schwerkraftrichtung und mit Kapillardurchmessern bevorzugt zwischen 0.1 - 0.5 mm, besonders bevorzugt 0.3 mm, aufweisen kann, und durch die Prozessgas geleitet werden kann. Das Kapillarrohr 503 kann dabei Bohrungen 502, bevorzugt seitlich und bevorzugt mit Bohrungsdurchmessern kleiner als die Kapillardurchmesser, z.B. < 0.1 mm, aufweisen, die in Verbindung zu den Kapillaren 504 stehen können, damit das Prozessgas, bevorzugt seitlich, ausströmen kann und sich gleichmäßig im Behälter verteilen kann.

Ferner ist denkbar, dass die Gaslanze aus einem nicht elektrisch leitenden Kern besteht, der jedoch gasdurchlässig für die Prozessgaszuführung sein kann. Dieser nicht elektrisch leitende Kern kann dann mit einem elektrisch leitenden Material umhüllt werden.

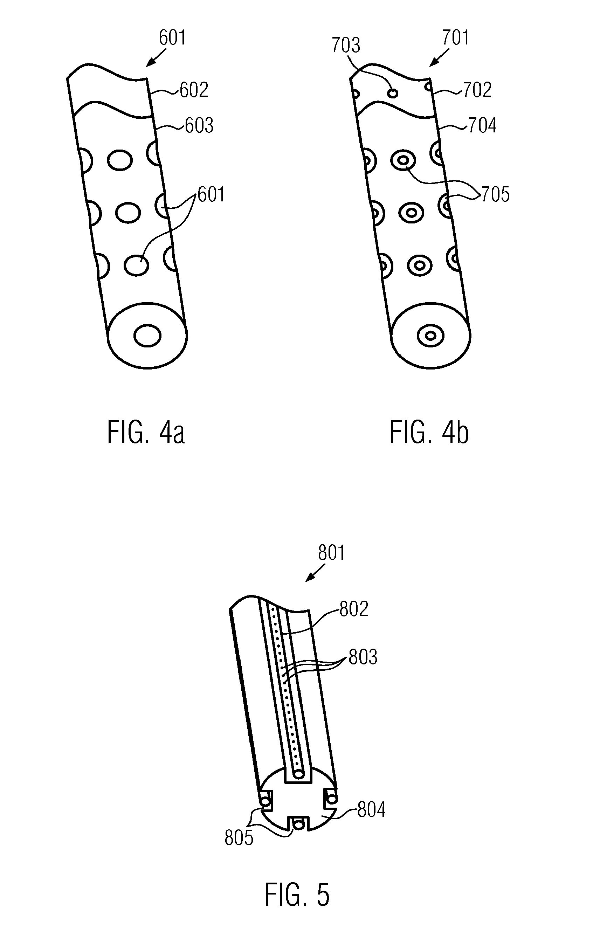

Fig. 4a stellt beispielsweise eine Gaslanze 601 dar, dessen Kern 602 ein elektrischer Isolator mit einem fein verzweigten labyrinthartigen Kanalsystem sein kann, wie z.B. ein Rohr aus offenporigem Keramikschaum mit Porengrößen <10-100 µm. Besagter Kern 602, kann eine metallische Hülle 603 aufweisen, wobei die metallische Hülle 603 z.B. ein metallisches Rohr mit Aussparungen 604 zum Durchlass von Prozessgas, ein metallischer Schaum mit gleicher oder verschiedener Porosität wie erwähnter Kern 602 aus porösem Keramikschaum, oder eine aufgedampfte metallische Umhüllung mit Öffnungen/Aussparungen 604, oder eine metallische Umhüllung mit netzartiger Struktur, zum Durchlass von Prozessgas sein kann. Die Öffnungen/Aussparungen 604 können beliebige Formen haben, z.B. rund, eckig, oder oval und beispielsweise mittlere Größen im Bereich von 1 bis 10 mm haben.

In Fig. 4b ist beispielhaft eine Variante der Gaslanze 701 aus Fig. 4a dargestellt, bei der die Gaslanze einen Kern 702 aus nicht elektrisch leitendem Material, z.B. Keramik, aufweist, der als Rohr ausgeführt sein kann, welches beispielsweise eine Vielzahl von Bohrungen 703, bevorzugt seitlich angebracht, aufweist, wobei die Bohrungsdurchmesser bevorzugt < 0.5 mm sind. Wie in Fig. 4a beschrieben, kann der Kern 702 eine metallische Hülle 704 aufweisen, wobei die metallische Hülle 704 z.B. ein metallisches Rohr mit Aussparungen 705 zum Durchlass von Prozessgas, ein metallischer, oder eine aufgedampfte metallische Umhüllung mit Aussparungen, oder eine metallische Umhüllung mit netzartiger Struktur, zum Durchlass von Prozessgas sein kann. Die Öffnungen/Aussparungen 705 können analog den Aussparungen 604 der Gaslanze 601 beliebige Formen haben, z.B. rund, eckig, oder oval und beispielsweise mittlere Größen im Bereich von 1 bis 10 mm haben.

Fig. 5 stellt beispielhaft eine Gaslanze 801 dar, deren Vollmaterialkern ein massives elektrisch leitendes Material 804 mit Vertiefungen 805, z.B. seitlich in Schwerkraftrichtung verlaufend, bilden kann. Die Vertiefungen können 1 bis 5 mm breit und ebenso tief sein.

In die Vertiefungen 805 können beispielsweise nicht elektrisch leitende Rohre oder Kapillare, z.B. Keramik-Kapillare 802, eingelassen sein, welche über Bohrungen 803 verfügen, bevorzugt seitlich angebracht, und beispielsweise mit Bohrungsdurchmessern, die kleiner als die Kapillardurchmesser sind, z.B. < 0.1 mm. Über besagte nicht elektrisch leitende Rohre oder Kapillare kann dann Prozessgas zugeführt werden.

Ein weiterer Vorteil der hier beschriebenen Gaslanzenausführungsbeispiele, welche Hohlkathodenentladungen innerhalb der Gaslanze minimieren, ist unter anderem, dass eine teilweise Umsetzung von Prozessgas bereits innerhalb der Gaslanze unterbunden, bzw. minimiert werden kann. So können unerwünschte plasma-aktivierte Abscheidungen, wie beispielsweise Siloxanfragmente, an den Gaseinlassöffnungen der Gaslanze vermieden oder reduziert werden. Solche unerwünschten Abscheidungen und/oder Ablagerungen können die Gaseinlassöffnungen teilweise oder sogar vollständig verschließen, wodurch sich die Prozessgasverteilung in der Flasche nachteilig ändern kann und es zu einer unzureichenden/mangelnden Prozessgasversorgung und folglich zu einer mangelhaftern und/oder unvollständigen Beschichtung kommen kann.

Ferner kann eine schädliche Überhitzung der Gaslanze, aufgrund Hohlkathodenentladungen bzw. Plasmabildung innerhalb der Gaslanze, durch beschriebene vorteilhafte Ausbildungen einer Gaslanze, vermieden, bzw. das Risiko einer Überhitzung der Gaslanze minimiert werden.

Unabhängig von einer der hier beschriebenen beispielhaften Varianten einer Gaslanze, welche in das Innere des zu behandelnden Behälters eingeführt werden kann, kann die Kontur die Gaslanze der Form des Behälters folgen. Somit kann vorteilhafterweise die Gleichmäßigkeit der Beschichtung der Behälterwand, im Vergleich zu einer nicht der Behälterform angepassten Gaslanze, verbessert werden.

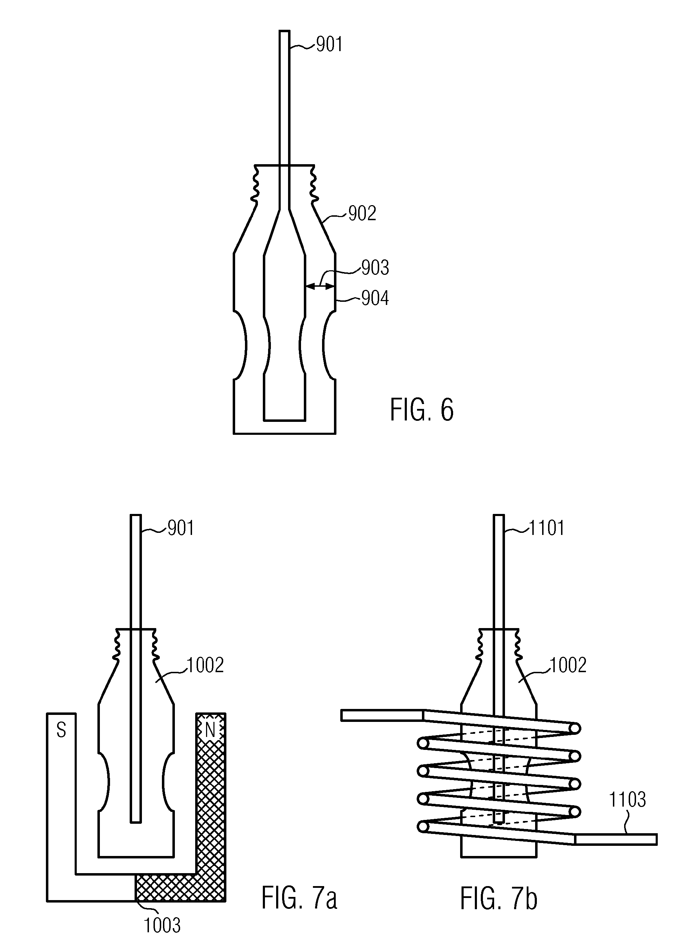

Dies ist in Fig. 6 beispielhaft veranschaulicht, worin die Kontur einer Gaslanze 901, der Innenkontur des Behälters 902 so folgen kann, dass der Abstand 903 zwischen Gaslanze und Behälterwand 904, im Mittel konstant ist, bis auf beispielsweise eine Toleranz in der Konstanz des Abstandes von weniger als 10, 20 oder 60 %.

Ebenso unabhängig von den bislang hier beschriebenen Beispielen für Gaslanzen und Behälterbeschichtungsvorrichtung kann im Innenbereich der zu behandelnden Behälter zusätzlich ein Magnetfeld erzeugt werden, um damit den Behälterbeschichtungsprozess zusätzlich beeinflussen zu können.

Das Magnetfeld kann z.B. durch ein oder mehrere Permanentmagnete oder elektrische Spulen in unterschiedlichster Orientierung ausserhalb der Behälter erzeugt werden. Ziel ist es, dass eine hohe Magnetfeldstärke im Inneren eines zu behandelnden Behälters erzeugt werden kann. Genannte Magnetfelderzeugende Elemente befinden sich dabei möglichst nahe au ßerhalb an der Behälterwand, z.B. in einem Abstand < 2 , 5, oder 10 mm zur Behälteraußenwand, um ein möglichst starkes Magnetfeld auf der inneren Oberfläche des Behälters erzeugen zu können. Das Magnetfeld bewirkt vorteilhafterweise, dass das Plasma intensiver wird, da die Elektronen in ihrer Bewegungsrichtung auf einen kleineren Raum eingeschränkt werden können.

Zur Homogenisierung des Effektes kann der Behälter während der Behandlung zusätzlich gedreht werden.

In Fig. 7a ist beispielhaft dargestellt, dass ein Magnetfeld im Innenbereich des zu behandelnden Behälters 1002, in dem sich eine Gaslanze 1001 befinden kann, mittels eines Permanentmagneten 1003 erzeugt werden kann.

In Fig. 7b ist beispielhaft dargestellt, dass ein Magnetfeld im Innenbereich des zu behandelnden Behälters 1102, in dem sich eine Gaslanze 1101 befinden kann, auch mittels einer Spule 1103 erzeugt werden kann.

Es folgen 6 Blatt mit 11 Figuren.

Die verwendeten Bezugszeichen sind dabei wie folgt belegt.
- **100**: Vorrichtung zur plasmaunterstützten Beschichtung eines Behälters.
- **113**: Grund-Druckkammer.
- **114**: Grund-Druckkammergehäuse.
- **111**: Prozess-Druckkammer.
- **110**: Prozess-Druckkammergehäuse.
- **112**: Zufuhr von Prozessgas
- **101,201,301,401,501,601,701,801,901,1001,1101**: Gaslanze/Powerlanze.
- **202**: Metallisches Rohr.
- **204**: Ende vom Rohr R1
- **603, 704**: Metallische Hülle.
- **604, 705**: Aussparung, Öffnung.
- **302**: Rohr aus porösem Metallschaum.
- **304**: Ende vom Rohr R2
- **108**: Koaxialkabel.
- **111**: Prozessgaszuführungsleitung.
- **107**: Elektrische Abschirmung.
- **103**: Au ßenelektrode.
- **106**: Leistungsanpassungseinheit für Radiofrequency Matching, sogenannte Matchbox.
- **109**: Hochfrequenzquelle.
- **104**: Ventil.
- **105**: Flaschenklammer.
- **102, 902, 1002, 1102**: Behälter, z.B. Kunststoffflasche.
- **903**: Abstand Gaslanze Behälterwand.
- **904**: Behälterwand.
- **403**: Doppelrohr.
- **405**: Innenrohr.
- **404**: Außenrohr.
- **406, 505**: Metallischer Kern.
- **702**: Nicht elektrisch leitender Kern.
- **602**: Nicht elektrisch leitender poröser Kern.
- **804**: Massiver Kern (Vollmaterialkern) aus elektrisch leitendem Material mit Vertiefungen.
- **503**: Kapillarrohr.
- **802**: Keramik-Kapillare.
- **504**: Kapillare.
- **805**: Vertiefung.
- **1003**: Permanentmagnet.
- **1103**: Elektromagnetische Spule.
- **202, 402, 502, 703, 803**: Bohrung, Gaseinlassbohrung, gasdurchlässige Bohrung.

## Patentansprüche

1. Vorrichtung (100) zur Beschichtung eines Behälters (102), beispielsweise einer Kunststoffflasche, mittels Plasmabehandlung, beinhaltend,
wenigstens eine Hochfrequenzquelle (109), wenigstens eine sich außerhalb des zu behandelnden Behälters (102) befindliche Außenelektrode (103), und wenigstens eine mindestens teilweise elektrisch leitende Gaslanze (101) zum Zuführen von Prozessgas in den Behälter (102), **dadurch gekennzeichnet, dass** die wenigstens eine Außenelektrode (103) geerdet ist und/oder auf dem gleichen Potential liegt wie andere sich außerhalb des zu behandelnden Behälters befindlichen Teile der Behälterbeschichtungsvorrichtung (100), wie etwa Druckkammerteile oder Gehäuseteile, und die wenigstens eine Gaslanze (101) eine von der Hochfrequenzquelle (109) erzeugbare Hochfrequenz in das Innere des zu behandelnden Behälters (102) einstrahlen kann.

2. Vorrichtung nach Anspruch 1, **dadurch gekennzeichnet, dass** die Gaslanze (101) mindestens teilweise, beispielsweise koaxial, elektrisch abgeschirmt ist, wobei die elektrische koaxiale Abschirmung (107) der Gaslanze (101) innerhalb des Behälters (102) enden kann.

3. Vorrichtung nach einem der vorigen Ansprüche 1 bis 2, **dadurch gekennzeichnet, dass** die Gaslanze (101) so ausgebildet ist, dass die Gaslanze (101) aus einem Material besteht, welches gleichzeitig elektrisch leitend und durchlässig für Prozessgas ist, beispielsweise ein metallisches Rohr, oder ein metallisches Rohr mit einer Vielzahl von Gaseinlassbohrungen, beispielsweise mit Bohrungsdurchmessern kleiner als 0.1, 0.2 oder 0.5 mm und Bohrungslängen von 0.1 - 10, 20 mm, oder aus einem porösem Metallschaum, beispielsweise aus mikroporösem Schaum aus Aluminium mit mittleren Porenradii von z.B < 10 - 100 µm.

4. Vorrichtung nach einem der vorigen Ansprüche 1 bis 3, **dadurch gekennzeichnet, dass** die Gaslanze so ausgebildet ist, dass die Zufuhr von Prozessgas und die Zufuhr, bzw. Leitung der Hochfrequenz räumlich getrennt erfolgt, wobei der die hochfrequenzleitende Teil der Gaslanze elektrisch leitend ist, und der prozessgaszuführende Teil der Gaslanze teilweise oder vollständig aus einem nichtelektrisch leitendem Material, z.B. Kunststoff oder Keramik, teilweise oder vollständig aus einem elektrisch leitendem Material, oder aus einer Kombination von elektrisch leitendem und nichtleitendem Material bestehen kann.

5. Vorrichtung nach Anspruch 4, **dadurch gekennzeichnet, dass** die Gaslanze (401) als Vollmaterial einen massiven metallischen Kern (406) aufweist, wobei der metallische Kern von einem Doppelrohr (403) zur Prozessgaszuführung, z.B. bestehend aus Kunststoff, umfasst ist, und die beiden Rohre (405, 404) des Doppelrohres (403) ineinander liegen und einen Abstand voneinander von 0.1-2 mm aufweisen, und das äußere Rohr (404) dabei Bohrungen (402), bevorzugt seitlich und bevorzugt mit Bohrungsdurchmessern < 0.5 mm, aufweist.

6. Vorrichtung nach Anspruch 4, **dadurch gekennzeichnet, dass** die Gaslanze (501) einen massiven metallischen Kern (505) aufweist, der von einem Kapillarrohr (503) zur Prozessgaszuführung, z.B. bestehend aus einem keramischen Material, umschlossen ist, und das Kapillarrohr Kapillare (504) aufweist, welche bevorzugt parallel zur Schwerkraftrichtung angeordnet sind, und Kapillardurchmessern bevorzugt zwischen 0.1 - 0.5 mm, bevorzugt 0.3 mm, aufweisen, und das Kapillarrohr (503) Bohrungen (502), bevorzugt seitlich und bevorzugt mit Bohrungsdurchmessern kleiner als die Kapillardurchmesser, z.B. < 0.1 mm, aufweist, die in Verbindung zu den Kapillaren (504) stehen.

7. Vorrichtung nach Anspruch 4, **dadurch gekennzeichnet, dass** die Gaslanze (601) einen Kern (602) aus einem elektrischen Isolator mit einem fein verzweigten labyrinthartigen Kanalsystem zur Prozessgaszuführung aufweist, wie z.B. ein Rohr aus porösem Keramikschaum mit z.B. mittleren Porenradii < 10-100 µm, und der Kern (602) von einer metallische Hülle (603) umgeben ist, und die metallische Hülle (603) z.B. ein metallisches Rohr mit Aussparungen (604) zum Durchlass von Prozessgas, oder ein metallischer Schaum mit gleicher oder verschiedener Porosität wie erwähnter Kern (602) aus porösem Keramikschaum, oder eine aufgedampfte metallische Umhüllung mit Öffnungen/Ausparungen (604), oder eine metallische Umhüllung mit netzartiger Struktur ist, wobei die Formen der Öffnungen/Aussparungen (604) z.B. rund, eckig, oder oval sind, und beispielsweise mittlere Größen im Bereich von 1 bis 10 mm haben.

8. Vorrichtung nach Anspruch 7, **dadurch gekennzeichnet, dass** die Gaslanze (701) einen Kern (702) aus nicht elektrisch leitendem Material, z.B. Keramik, zur Prozessgaszuführung aufweist, der als Rohr ausgeführt ist, und welches eine Vielzahl von Bohrungen (703), bevorzugt seitlich angebracht, aufweist, wobei die Bohrungsdurchmesser bevorzugt < 0.5 mm sind, und der Kern (702) von einer metallische Hülle (MH) umgeben ist, wobei die metallische Hülle (MH) z.B. ein metallisches Rohr mit Aussparungen (705) zum Durchlass von Prozessgas, ein metallischer, oder eine aufgedampfte metallische Umhüllung mit Aussparungen (705), oder eine metallische Umhüllung mit netzartiger Struktur, zum Durchlass von Prozessgas ist, wobei die Formen der Öffnungen/Aussparungen (705) z.B. rund, eckig, oder oval sind, und beispielsweise mittlere Größen im Bereich von 1 bis 10 mm haben.

9. Vorrichtung nach Anspruch 4, **dadurch gekennzeichnet, dass** die Gaslanze (801) einen Vollmaterialkern (804) aus elektrisch leitendem Material aufweist, und der Vollmaterialkern (804) Vertiefungen (805), z.B. seitlich in Schwerkraftrichtung verlaufend, aufweist, und die Vertiefungen (805) nicht elektrisch leitende Rohre oder Kapillare, z.B. Keramik-Kapillare (802), zur Prozessgaszuführung beherbergen, welche Bohrungen (803) aufweisen, bevorzugt seitlich angebracht, und beispielsweise mit Bohrungsdurchmessern kleiner als die Kapillardurchmesser, z.B. < 0.1 mm.

10. Vorrichtung nach einem der vorigen Ansprüche 1 bis 9, **dadurch gekennzeichnet, dass** die Gaslanze (901) so ausgebildet ist, dass die Kontur der Gaslanze (901), der Innenkontur des Behälters (902) folgt, und dass der Abstand (903) zwischen Gaslanze (901) und Behälterwand (904), im Mittel konstant ist, bis auf beispielsweise eine Toleranz in der Konstanz des Abstandes (903) von weniger als 10, 20 oder 60 %.

11. Vorrichtung nach einem der vorigen Ansprüche 1 bis 10, **dadurch gekennzeichnet, dass** innerhalb des zu behandelnden Behälters ein magnetisches Feld erzeugt werden kann, beispielsweise durch einen oder mehrere Permanentmagnete (1003) oder eine elektrische Spule (1103) ausserhalb der Behälter.

12. Vorrichtung nach einem der vorigen Ansprüche 1 bis 11, **dadurch gekennzeichnet, dass** die Behälterbeschichtungsvorrichtung so konfiguriert ist, dass das Innere des Behälters evakuiert werden kann, beispielsweise auf einen Druckbereich zwischen 1 und 30 Pa, und der Bereich außerhalb des Behälters teilweise oder vollständig auf einen vom Inneren des Behälters verschiedenen Druckbereich, beispielsweise 100 - 4000 Pa, evakuiert werden kann.

13. Verfahren zur plasmaunterstüzten Beschichtung eines Behälters (102), welches beinhaltet, dass dem zu behandelnden Behälter (102) über eine ungeerdete Gaslanze (101) Prozessgas und eine Hochfrequenz, die an eine sich außerhalb des Behälters (102) befindliche geerdete Außenelektrode (103) ankoppelt, zugeführt wird, und dass im Inneren des Behälters das Prozessgas in einem Plasma teilweise oder vollständig umgesetzt wird, und durch Gasphasenabscheidung das Innere des Behälters (102) beschichtet wird.
